# EUROPEAN PATENT APPLICATION

(11) **EP 0 939 440 A2**
(43) Date of publication of application: **01.09.1999**
(21) Application number: 99103708.6
(22) Date of filing: 25.02.1999
(51) Int. Cl.: H01L 23/29

(54) **Process for producing semiconductor device package and organopolysiloxane composition used therefor**

(30) Priority: 25.02.1998 JP 6054098
(71) Applicant: SHIN-ETSU CHEMICAL CO., LTD., Chiyoda-ku Tokyo (JP)
(72) Inventor: Ikeno, Masayuki, c/o Silicone Denshi Zairyo Co.Ltd, Usui-gun, Gunma-ken (JP)
(74) Representative: von Füner, Alexander, Prof.h.c. Dr.

(57) **Abstract**

A process for producing a semiconductor device package, comprising the steps of putting in a casing a substrate on which a semiconductor device has been mounted, and potting the semiconductor-mounted substrate with an addition-curable organopolysiloxane composition in the casing. The composition shows a Young's modulus of from 1 to 12 kgf/cm² after its curing, undergoes less change in the Young's modulus with time and therefore is less causative of stress by strain. Thus, semiconductor device packages can be obtained which may cause no cracking in semiconductor-mounted substrates.

## Description

### BACKGROUND OF THE INVENTION

### 1. Field of the Invention

This invention relates to a process for producing a semiconductor device package by using an addition-curable organopolysiloxane composition that can form a cured product less causative of stress by strain, and also relates to an addition-curable organopolysiloxane composition suited as a potting material used in this process.

### 2. Description of the Prior Art

Because of superior adhesion, electrical properties, mechanical properties, moisture resistance and so forth, epoxy resins have been used as electrical insulating materials for the potting of printed circuit boards on which electronic component parts such as diodes, transistors, integrated circuits (including ICs, LSIs and super-LSIs) or memory devices have been mounted or the potting of hybrid ICs. As an example, the epoxy resins are used in semiconductor device packages, which are produced by putting in a casing a substrate on which semiconductor devices have been mounted (hereinafter often "semiconductor-mounted substrate") and potting the semiconductor-mounted substrate with epoxy resin in this casing. However, as electric and electronic component parts are manufactured in a higher packaging density and a higher integration, the epoxy resin may undergo a great stress as a result of heat generation in the substrate on which electric and electronic component parts have been mounted, and become strained to cause a problem of, e.g., cracking of the substrate. Accordingly, in order to prevent strain from being caused by such stress, it is attempted to use as a potting material an addition-curable silicone rubber (organopolysiloxane) composition in place of the epoxy resin. However, no satisfactory strain preventive effect has been attained.

### SUMMARY OF THE INVENTION

Accordingly, an object of the present, invention is to provide a process for producing a semiconductor device package by using as a potting material an addition-curable organopolysiloxane composition that can form a cured product having a low modulus of elasticity, in particular, a low Young's modulus, undergoing less change in the Young's modulus with time and therefore less causative of stress by strain, to obtain a semiconductor device package that may cause no cracking in semiconductor-mounted substrates.

Another object of the present invention is to provide an addition-curable organopolysiloxane composition for potting electronic component parts, suited as the above potting material.

The present invention provides a process for producing a semiconductor device package, comprising the steps of putting in a casing a substrate on which a semiconductor device has been mounted, and potting the semiconductor-mounted substrate with an addition-curable organopolysiloxane composition in the casing; the composition showing a Young's modulus of from 1 to 12 kgf/cm² after its curing.

The present invention also provides an addition-curable organopolysiloxane composition for potting electronic component parts, comprising:
(A) 100 parts by weight of an organopolysiloxane having at least two alkenyl groups in one molecule;
(B) from 0.1 to 50 parts by weight of an organohydrogenpolysiloxane having in one molecule at least two hydrogen atoms bonded to silicon atoms; and
(C) an effective amount of a catalyst for hydrosilylation reaction; and
having a Young's modulus of from 1 to 12 kgf/cm² after its curing;
which is suited as the potting material used in the above production process.

The addition-curable organopolysiloxane composition of the present invention has a low modulus of elasticity, in particular, a low Young's modulus, undergoes less change in the Young's modulus with time and therefore is less causative of stress by strain. Thus, when a semiconductor device package is produced using this composition as a potting material, semiconductor device packages can be obtained which may cause no cracking in semiconductor-mounted substrates.

### BRIEF DESCRIPTION OF THE DRAWINGS

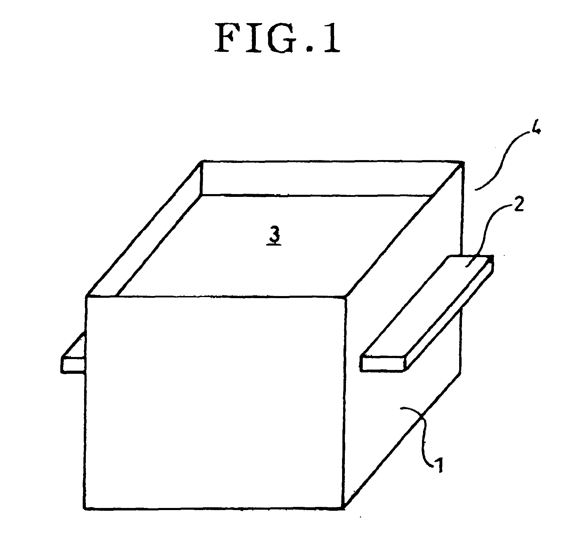

Fig. 1 is a perspective view of a testing artificial semiconductor device package prepared in Examples and Comparative Examples.

### DESCRIPTION OF THE PREFERRED EMBODIMENTS

The semiconductor device package according to the present invention is produced in the following way: First a substrate on which semiconductor devices have been mounted is put in a casing at its predetermined position. Thereafter, the addition-curable organopolysiloxane composition having a Young's modulus of from 1 to 12 kgf/cm² after its curing is injected into the casing, followed by curing, thus the semiconductor-mounted substrate is potted with the composition. In the present invention, what is meant by "putting the substrate in the casing embraces not only an instance where a substrate having length and breadth both of which are smaller than the inner length and breadth of the casing is put in the casing, but also an instance where a substrate having length and breadth either of which is larger than the inner length and breadth of the casing is put in the casing in the manner it extends through the both sidewalls of the casing.

As examples of the addition-curable organopolysiloxane composition used in the process of the present invention, it may typically include those comprising;
(A) 100 parts by weight of an organopolysiloxane having at least two alkenyl groups in one molecule;
(B) from 0.1 to 50 parts by weight of an organohydrogenpolysiloxane having in one molecule at least two hydrogen atoms bonded to silicon atoms; and
(C) an effective amount of a catalyst for hydrosilylation reaction; and
capable of forming a cured product having a Young's modulus of from 1 to 12 kgf/cm² after its curing.

In the both components (A) and (B) constituting the addition-curable organopolysiloxane composition of this type, a cyclic siloxane having a degree of polymerization of from 3 to 10 and being usually non-functional (hereinafter "D₃-D₁₀ component") is usually contained as an impurity. Also, as will be described later, the composition of the present invention may contain as optional components an organopolysiloxane and an organosilicon compound which are different from both the components (A) and (B). There is a possibility that the D₃-D₁₀ component is contained also in these different organopolysiloxane and organosilicon compound. In the addition-curable organopolysiloxane composition used in the present invention, the D₃-D₁₀ component contained in the composition may preferably be controlled to be not more than 1,000 ppm, and particularly from 0 to 600 ppm, by weigh in total in order to prevent semiconductor devices from their deterioration due to volatilization of these impurities.

The constituents of the addition-curable organopolysiloxane composition will be described below in detail.

### (A) Alkenyl-group-containing organopolysiloxane:

The component-(A) alkenyl-group-containing organopolysiloxane is a base polymer of this composition, and contains at least two alkenyl groups in one molecule. This alkenyl group may include those having usually 2 to 8 carbon atoms in approximation, such as a vinyl group, an allyl group, a propenyl group, an isopropenyl group, a butenyl group, an isobutenyl group, a hexenyl group, a heptenyl group, a cyclohexenyl group and a cycloheptenyl group. In particular, lower alkenyl groups having 2 to 4 carbon atoms such as a vinyl group and an allyl group are preferred. These alkenyl groups may be those bonded to either of i) silicon atoms present at the terminals of the molecular chain and ii) silicon atoms present in the molecular chain at its position other than the terminals, or may be those bonded to both of these. In view of physical properties of the cured product, this component may preferably contain alkenyl groups bonded to both terminals of the molecular chain.

In the component (A), as organic groups bonded to silicon atoms, other than the alkenyl group, it may include substituted or unsubstituted monovalent hydrocarbon groups containing 1 to 12 carbon atoms, preferably 1 to 8 carbon atoms other than alkenyl groups, for example, alkyl groups such as a methyl group, an ethyl group, a propyl group, an isopropyl group, a butyl group, an isobutyl group, a tert-butyl group, a pentyl group, a hexyl group. a heptyl group, a 2-ethylhexyl group and an octyl group: cycloalkyl groups such as a cyclopentyl group and a cyclohexyl group; aryl groups such as a phenyl group, a tolyl group, a xylyl group and a naphthyl group; aralkyl groups such as a benzyl group, a phenylethyl group and a phenylpropyl group; as well as groups comprising any of these groups at least part of hydrogen atoms bonded to carbon atoms of which has been substituted with a halogen atom such as fluorine, chlorine or bromine or a cyano group, as exemplified by alkyl halide groups such as a chloromethyl group, a 2-bromoethyl group, a 3-chloropropyl group and a 3,3,3-trifluoropropyl group; a chlorophenyl group; a fluorophenyl group; and a cyanoethyl group: except for the alkenyl group. In particular, a methyl group and a phenyl group are preferred. Such a component (A) may have any molecular structure including, e.g., straight-chain, partially branched straight-chain, cyclic, branched-chain and three-dimensional network (resin) structures.

The component (A) may preferably have a viscosity at 25°C within the range of from 10 to 500,000 cP, and particularly within the range of from 50 to 100,000 cP, taking account of good handling operability of the composition and good physical properties of silicone rubber obtained by curing the composition.

Such a component-(A) alkenyl-group-containing organopolysiloxane may include, e.g., methylvinylsiloxane cyclic copolymers, methylvinylsiloxane-dimethylsiloxane cyclic copolymers, dimethylsiloxane-methylvinylsiloxane copolymers terminated with trimethylsiloxyl groups at both terminals of the molecular chain, methylvinylpolysiloxanes terminated with trimethylsiloxyl groups at both terminals of the molecular chain, dimethylsiloxane-methylvinylsiloxane-methylphenylsiloxane copolymers terminated with trimethylsiloxyl groups at both terminals of the molecular chain, dimethylpolysiloxanes terminated with dimethylvinylsiloxyl groups at both terminals of the molecular chain, methylvinylpolysiloxanes terminated with dimethylvinylsiloxyl groups at both terminals of the molecular chain, dimethylsiloxane-methylvinylsiloxane copolymers terminated with dimethylvinylsiloxyl groups at both terminals of the molecular chain, dimethylsiloxane-methylvinylsiloxane-methylphenylsiloxane copolymers terminated with dimethylvinylsiloxyl groups at both terminals of the molecular chain, dimethylpolysiloxanes terminated with methyldivinylsiloxyl groups at both terminals of the molecular chain, dimethylpolysiloxanes terminated with trivinylsiloxyl groups. at both terminals of the molecular chain, organopolysiloxane copolymers consisting of a siloxane unit represented by the formula: R¹₃SiO_{1/2} (wherein R¹ is a monovalent hydrocarbon group except for an alkenyl group; the same applies hereinafter), a siloxane unit represented by the formula: R¹₂R²SiO_{1/2} (wherein R² is an alkenyl group; the same applies hereinafter), a siloxane unit represented by the formula: R¹₂SiO_{2/2} and a small amount of a siloxane unit represented by the formula: SiO_{4/2}, organopolysiloxane copolymers consisting of the R¹₃SiO_{1/2} unit, the R¹₂R²SiO_{1/2} unit and the SiO_{4/2} unit, organopolysiloxane copolymers consisting of the R¹₂R²SiO_{1/2} unit, the R¹₂SiO_{2/2} unit and a small amount of the SiO_{4/2} unit, and organopolysiloxane copolymers consisting of an R¹R²SiO_{2/2} unit and a small amount of an R¹SiO_{3/2} unit and/or an R²SiO_{3/2} unit. Any of these alkenyl-group-containing organopolysiloxanes may be used alone or in combination of two or more. Incidentally, examples of the R¹ monovalent hydrocarbon group except for the alkenyl group and R² alkenyl group are as described previously.

### (B) Organohydrogenpolysiloxane:

The component-(B) organohydrogenpolysiloxane is a cross-linking agent of this composition, and contains in one molecule at least two, and preferably at least three, hydrogen atoms bonded to silicon atoms (i.e., SiH groups). In the component (B), as the position at which the hydrogen atoms are bonded to silicon atoms, the hydrogen atom may be bonded to a silicon atom present at a terminal of a molecular chain and/or a silicon atom present in the molecular chain at its position other than the terminal. In the component (B), as an organic group bonded to the silicon atom, like the case of the component (A), it may include substituted or unsubstituted monovalent hydrocarbon groups containing 1 to 12 carbon atoms, preferably 1 to 8 carbon atoms other than alkenyl groups, for example, alkyl groups such as a methyl group, an ethyl group, a propyl group, an isopropyl group, a butyl group, an isobutyl group, a tert-butyl group, a pentyl group, a hexyl group, a heptyl group, a 2-ethylhexyl group and an octyl group; cycloalkyl groups such as a cyclopentyl group and a cyclohexyl group; aryl groups such as a phenyl group, a tolyl group, a xylyl group and a naphthyl group; aralkyl groups such as a benzyl group, a phenylethyl group and a phenylpropyl group; as well as groups comprising any of these groups at least part of hydrogen atoms bonded to carbon atoms of which has been substituted with a halogen atom such as fluorine, chlorine or bromine or a cyano group, as exemplified by alkyl halide groups such as a chloromethyl group, a 2-bromoethyl group, a 3-chloropropyl group and a 3,3,3-trifluoropropyl group: a chlorophenyl group; a fluorophenyl group; and a cyanoethyl group; except for the alkenyl group. In particular, a methyl group and a phenyl group are preferred. Such a component (B) may have any molecular structure including. e.g., straight-chain, partially branched straight-chain, cyclic, branched-chain and three-dimensional network (resin) structures.

The component (B) may preferably have a viscosity at 25° C within the range of from 1 to 1,000 cP, and more preferably within the range of from 5 to 1,000 cP, taking account of good handling operability of the resultant composition and good physical properties of silicone rubber which is a cured product of the composition.

Such a component-(B) organohydrogenpolysiloxane may include, e.g., methylhydrogensiloxane cyclic copolymers, methylhydrogensiloxane-dimethylsiloxane cyclic copolymers, methylhydrogenpolysiloxanes terminated with trimethylsiloxyl groups at both terminals of the molecular chain, dimethylsiloxane-methylhydrogensiloxane copolymers terminated with trimethylsiloxyl groups at both terminals of the molecular chain, methylhydrogen-diphenylsiloxane copolymers terminated with trimethylsiloxyl groups at both terminals of the molecular chain, dimethylsiloxanemethylhydrogensiloxane-diphenylsiloxane copolymers terminated with trimethylsiloxyl groups at both terminals of the molecular chain, dimethylpolysiloxanes terminated with dimethylhydrogensiloxyl groups at both terminals of the molecular chain, dimethylsiloxane-methylhydrogensiloxane copolymers terminated with dimethylhydrogensiloxyl groups at both terminals of the molecular chain, dimethylsiloxanemethylhydrogensiloxane-diphenylsiloxane copolymers terminated with dimethylhydrogensiloxyl groups at both terminals of the molecular chain, dimethylsiloxanemethylphenylsiloxane copolymers terminated with dimethylhydrogensiloxyl groups at both terminals of the molecular chain, methylhydrogensiloxane-diphenylsiloxane copolymers terminated with dimethylhydrogensiloxyl groups at both terminals of the molecular chain, methylphenylpolysiloxanes terminated with dimethylhydrogensiloxyl groups at both terminals of the molecular chain, diphenylpolysiloxanes terminated with dimethylhydrogensiloxyl groups at both terminals of the molecular chain, organohydrogenpolysiloxane copolymers consisting of a siloxane unit represented by the formula: R¹₃SiO_{1/2}, a siloxane unit represented by the formula: R¹₂HSiO_{1/2} and a small amount of a siloxane unit represented by the formula: SiO_{4/2}, organohydrogenpolysiloxane copolymers consisting of a siloxane unit represented by the formula: R¹₂HSiO_{1/2} and a small amount of a siloxane unit represented by the formula: SiO_{4/2}, and organohydrogenpolysiloxane copolymers consisting of a siloxane unit represented by the formula: R¹HSiO_{2/2}, a siloxane unit represented by the formula: R¹SiO_{3/2} unit and a small amount of a siloxane unit represented by the formula: HSiO_{3/2} unit. Any of these organohydrogenpolysiloxanes may be used alone or in combination of two or more. Specific examples of the R¹ monovalent hydrocarbon group except for the alkenyl group may include the same groups as those for R¹ in the component (A).

The component (B) is mixed in an amount ranging from 0.1 to 50 parts by weight based on 100 parts by weight of the component (A). If it is mixed in an amount less than 0.1 part by weight, the composition may not cure sufficiently. If it is in an amount more than 50 parts by weight, the silicone rubber obtained by curing the composition may change in physical properties with time, or the composition does not cure in some cases. This component (B) may also be mixed, for the same reasons as the above, in such an amount that the hydrogen atoms bonded to silicon atoms (i.e., SiH groups) in the component (B) are in a molar ratio of from 0.4 to 10 (mol/mol), and preferably from 0.8 to 3 (mol/mol), with respect to the alkenyl groups in the component (A).

### (C) Hydrosilylation reaction catalyst:

The component-(C) catalyst is a catalyst of Group VIII of the periodic table, such as platinum group metal catalysts for accelerating hydrosilylation reaction, and may include, e.g., platinum group catalysts such as fine platinum powder, platinum black, platinum-supported fine silica powder, platinum-supported activated carbon, chloroplatinic acid, chloroplatinic acid alcohol solution, complexes of platinum with olefins and complexes of platinum with alkenylsiloxanes; palladium group catalysts such as tetrakis(triphenylphosphine)palladium; rhodium group catalysts: and fine powders of thermoplastic resins (e.g., acrylic resin, polycarbonate resin, methyl cellulose resin, polysilane resin. polyamide resin, polyester resin and polypropylene resin) containing any of these catalysts.

The component (C) may be mixed in a catalytic quantity sufficient for the curing of the composition, i.e., in an effective amount. Stated specifically, it may preferably be in an amount of from 0.1 to 500 ppm, and particularly from 1 to 100 ppm, by weight in terms of platinum group metal atoms, based on the weight of the component (A).

### Other components:

In addition to the components (A) to (C) described above, this composition may further contain optional components including, e.g., inorganic fillers such as fumed silica, crystalline silica (quartz powder), precipitated silica, fumed titanium dioxide, magnesium oxide, zinc oxide, iron oxide, aluminum hydroxide, magnesium carbonate, calcium carbonate, zinc carbonate, banded mica, carbon black, diatomaceous earth and glass fiber, and any of these fillers having been surface-treated with an organosilicon compound such as an organoalkoxysilane compound, an organochlorosilane compound. an organosilazane compound or a low molecular weight siloxane compound.

In order to improve handling operability of this composition, a cure retarder may be mixed. The cure retarder may include, e.g., alkyne alcohols such as 3-methyl-1-butyn-3-ol, 3,5-dimethyl-1-hexyn-3-ol and 2-phenyl-3-butyn-2-ol; enyne compounds such as 3-methyl-3-penten-1-yne and 3,5-dimethyl-3-hexen-1-yne; and 1,3,5,7-tetramethyl-1,3,5,7-tetravinylcyclotetrasiloxane, 1,3,5,7-tetramethyl-1,3,5,7-tetrahexenylcyclotetrasiloxane, and benzotriazole. Any of these cure retarders may preferably be mixed in an amount ranging from 10 to 50,000 ppm by weight based on the weight of the composition.

In addition to the foregoing, this composition may also be mixed with a hardness adjuster or adhesive agent including, e.g., organosilicon compounds such as organopolysiloxanes having in one molecule one hydrogen atom bonded to a silicon atom (i.e., SiH group) or an alkenyl group, organopolysiloxanes having neither hydrogen atom bonded to a silicon atom nor an alkenyl group, organopolysiloxanes having in one molecule a hydrogen atom bonded to a silicon atom or an alkenyl group and an alkoxyl group bonded to a silicon atom, silanes having in one molecule an alkoxyl group bonded to a silicon atom and an epoxy group or their partial hydrolysis-condensation products (siloxane oligomers). and silanes having in one molecule an alkoxyl group bonded to a silicon atom and a methacryloxyl group or their partial hydrolysis-condensation products (siloxane oligomers); an adhesion accelerator; an organic solvent; an anti-creep-hardening agent; a storage stabilizer; a heat resistant agent; a flame retardant agent; a plasticizer; a thixotropic agent; a pigment; a dye; a mildewproofing agent; and so forth. These may be mixed in such an amount that the effect of the present invention is not damaged.

### Preparation of composition:

To prepare the present composition, when prepared as a one-pack type composition, the components (A) to (C) and, as occasion calls, the optional components may be mixed uniformly. When prepared as a two- or more-pack type composition, the components (A) to (C) and, as occasion calls, the optional components may be divided into appropriate two or more packs, and the respective packs may be mixed uniformly. These may be mixed by means of, e.g., a Ross mixer or a planetary mixer, either of which may be used. In the case of the one-pack type composition, it must be stored or refrigerated at 25° C or below, and preferably 10°C or below, before use. As for the case of the two- or more-pack type composition, the packs before use may be stored at room temperature and all the packs may be mixed uniformly when used.

The composition of the present invention can be cured into a low-elasticity rubber-like or gel-like elastic material usually under heating conditions of from 60° C to 150° C and from 60 minutes to 120 minutes in approximation (e.g., 60° C x 120 minutes to 150° C 60 minutes), provided that, after it has been cured under the above conditions, its cured product is required to have a Young's modulus within the range of from 1 to 12 kgf/cm². If it has a Young's modulus less than 1 kgf/cm², the cured product may be so soft as to cause a problem that the substrate on which semiconductor devices have been mounted can not be fixed well stably during vibration. If on the other hand it has a Young's modulus more than 12 kgf/cm², the cured product may be so hard as to lack in stress relaxation to have a disadvantage that the semiconductor-mounted substrate may crack. This Young's modulus may preferably be within the range of from 2 to 10 kgf/cm².

### EXAMPLES

The present invention will be described below in greater detail by giving Examples and Comparative Examples. In the following, viscosity refers to a viscosity measured at 25° C; and "part(s)" and "ppm", those by weight. Letter symbol Me represents a methyl group, and Vi a vinyl group.

### Example 1

72 parts of a dimethylpolysiloxane (a base polymer) terminated with dimethylvinylsiloxyl groups at both terminals of the molecular chain, having a viscosity of 10,000 cP, 28 parts of a dimethylpolysiloxane (a base polymer) terminated with dimethylvinylsiloxyl groups at both terminals of the molecular chain, having a viscosity of 5,000 cP, 0.6 part of triallylisocyanurate, 0.6 part of methylhydrogenpolysiloxane represented by the following average molecular formula (1): 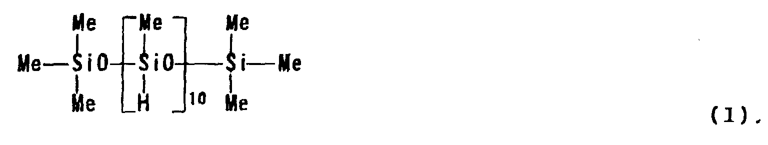 1.3 parts of a compound (an adhesive agent) represented by the following formula (2): 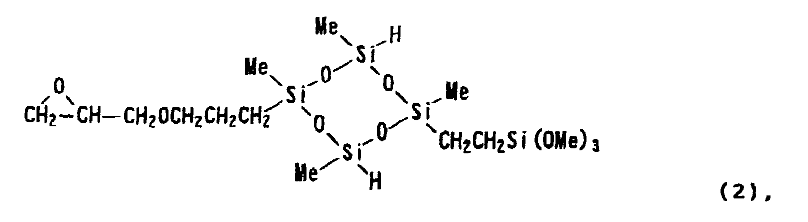 0.2 part of 1-ethynylcyclohexanol and 0.2 part of a platinum complex of 1,1,3,3-tetramethyl-1,3-divinyldisiloxane (in the amount corresponding to 20 ppm in terms of the platinum metal atom, based on the total weight of the base polymers) were mixed to prepare an addition-curable organopolysiloxane composition. In the composition obtained, D₃-D₁₀ components were in a content of 500 ppm in total.

Next, as shown in Fig. I (in the drawing, reference numeral 1 denotes a casing made of aluminum; 2, a ceramic substrate (no semiconductor device is mounted); 3, a potting material; and 4, a testing artificial semiconductor device package), the ceramic substrate 2 measuring 40 mm x 25 mm x 0.8 mm was put in the casing 1 made of aluminum (inner size: 30 mm long x 40 mm deep x 30 mm wide) in the manner it extended through the both sidewalls of the casing. Thereafter, as the potting material 3, the above composition was injected into it, and then cured at 150° C for 30 minutes to produce the testing artificial semiconductor device package 4.

Using the same organopolysiloxane composition as the above, a column-like cured product (a sample for measurement of modulus of elasticity) of 50 mm φ in diameter and 100 mm in height was produced under curing conditions of 150° C for 30 minutes. On this sample. Young's modulus was measured from the gradient of a strain-load curve obtained when compressed by 5% in the vertical direction. On the same sample, Young's modulus was also measured similarly after it was left at 150° C for 100 hours. The results are shown in Table 1.

As a substrate cracking test, this package was left at 150° C for 100 hours to observe the state of the substrate. The results are also shown in Table 1.

### Example 2

77.5 parts of a dimethylpolysiloxane (a base polymer) terminated with dimethylvinylsiloxyl groups at both terminals of the molecular chain, having a viscosity of 5,000 cP, 22.5 parts of an organopolysiloxane copolymer (a base polymer) consisting of 38.9 mol% of an Me₃SiO_{1/2}unit, 5.6 mol% of a ViMe₂SiO_{1/2} unit and 55.5 mol% of an SiO_{4/2} unit, 0.3 part of triallylisocyanurate, 1 part of methylhydrogenpolysiloxane of the above average molecular formula (1), 3.2 parts of a compound of the above formula (2), 0.9 part of a compound (an adhesive auxiliary) represented by the following formula (3): 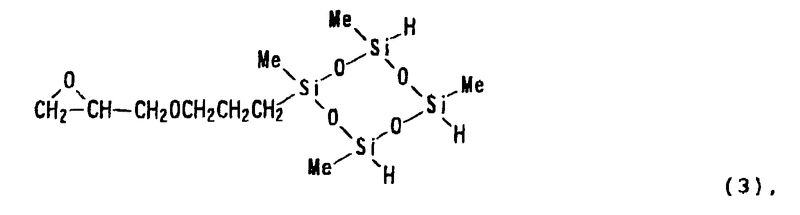 60 parts of precipitated silica having an average particle diameter of 5 µm, 0.2 part of 1-ethynylcyclohexanol and 0.2 part of a platinum complex of 1,1,3,3-tetramethyl-1.3-divinyldisiloxane (in the amount corresponding to 20 ppm in terms of the platinum metal atom, based on the total weight of the base polymers) were mixed to prepare an addition-curable organopolysiloxane composition. In the composition obtained. D₃-D₁₀ components were in a content of 400 ppm in total.

Subsequently. using this composition, a testing artificial semiconductor device package was produced. Young's modulus of the cured product was measured and also the substrate cracking test was made all in the same manner as in Example 1. The results are shown in Table 1.

### Example 3

43 parts of a dimethylpolysiloxane (a base polymer) terminated with dimethylvinylsiloxyl groups at both terminals of the molecular chain, having a viscosity of 600 cP, 57 parts of a dimethylpolysiloxane (a base polymer) terminated with dimethylvinylsiloxyl groups at both terminals of the molecular chain, having a viscosity of 5,000 cP. 0.3 part of triallylisocyanurate, 3 parts of a dimethylsiloxane-methylhydrogensiloxane copolymer represented by the following average molecular formula (4): 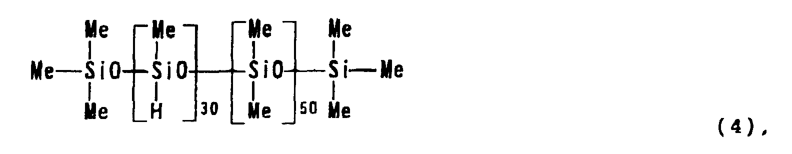 35 parts of precipitated silica having an average particle diameter of 5 µm, 0.2 part of 1-ethynylcyclohexanol and 0.2 part of a platinum complex of 1,1,3,3-tetramethyl-1,3-divinyldisiloxane (in the amount corresponding to 20 ppm in terms of the platinum metal atom, based on the total weight of the base polymers) were mixed to prepare an addition-curable organopolysiloxane composition. In the composition obtained, D₃-D₁₀ components were in a content of 400 ppm in total.

Subsequently, using this composition, a testing artificial semiconductor device package was produced, Young's modulus of the cured product was measured and also the substrate cracking test was made all in the same manner as in Example 1. The results are shown in Table 1.

### Comparative Example 1

15 parts of a dimethylpolysiloxane (a base polymer) terminated with dimethylvinylsiloxyl groups at both terminals of the molecular chain, having a viscosity of 1,000 cP, 60 parts of a dimethylpolysiloxane (a base polymer) terminated with dimethylvinylsiloxyl groups at both terminals of the molecular chain, having a viscosity of 5,000 cP, 22.5 parts of an organopolysiloxane copolymer (a base polymer) consisting of 38.9 mol% of an Me₃SiO_{1/2} unit, 5.6 mol% of a ViMe₂SiO_{1/2} unit and 55.5 mol% of an SiO_{4/2} unit, 10 parts of a dimethylsiloxane-methylhydrogensiloxane copolymer represented by the above average molecular formula (4), 0.2 part of 1-ethynylcyclohexanol and 0.2 part of a platinum complex of 1,1,3,3-tetramethyl-1,3-divinyldisiloxane (in the amount corresponding to 20 ppm in terms of the platinum metal atom, based on the total weight of the base polymers) were mixed to prepare an addition-curable organopolysiloxane composition. In the composition obtained, D₃-D₁₀ components were in a content of 400 ppm in total.

Subsequently, using this composition, a testing artificial semiconductor device package was produced, Young's modulus of the cured product was measured and also the substrate cracking test was made all in the same manner as in Example 1. The results are shown in Table 1.

### Comparative Example 2

100 parts of a dimethylpolysiloxane (a base polymer) terminated with dimethylvinylsiloxyl groups at both terminals of the molecular chain, having a viscosity of 400 cP, 4 parts of a dimethylsiloxane-methylhydrogensiloxane copolymer represented by the following average molecular formula (5): 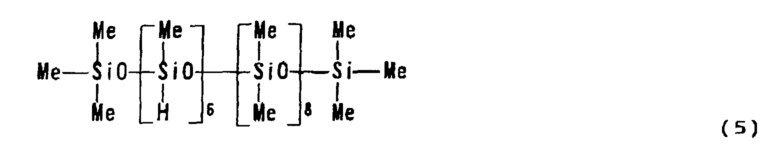 7 parts of a compound represented by the above formula (2), 200 parts of crystalline silica, 0.2 part of 1-ethynylcyclohexanol and 0.2 part of a platinum complex of 1,1,3,3-tetramethyl-1,3-divinyldisiloxane (in the amount corresponding to 20 ppm in terms of the platinum metal atom, based on the total weight of the base polymer) were mixed to prepare an addition-curable organopolysiloxane composition. In the composition obtained, D₃-D₁₀ components were in a content of 400 ppm in total.

Subsequently. using this composition, a testing artificial semiconductor device package was produced, Young's modulus of the cured product was measured and also the substrate cracking test was made all in the same manner as in Example 1. The results are shown in Table 1.

**Table 1**

| | Example 1 | Example 2 | Example 3 | Comparative Example 1 | Comparative Example 2 |
|---|---|---|---|---|---|
| Initial Young's modulus of cured product | 2 | 10 | 8 | 22 | 40 |
| Young's modulus of cured product after 150° C x 100 hours | 2 | 12 | 8 | 30 | 40 |
| State of ceramic substrate after 150° C x 100 hours | No changes | No changes | No changes | Cracked | Cracked |

## Claims

1. A process for producing a semiconductor device package. comprising the steps of putting in a casing a substrate on which a semiconductor device has been mounted, and potting the semiconductor-mounted substrate with an addition-curable organopolysiloxane composition in the casing; the composition showing a Young's modulus of from 1 kgf/cm² to 12 kgf/cm² after its curing.

2. The process according to claim 1, wherein said addition-curable organopolysiloxane composition comprises:
(A) 100 parts by weight of an organopolysiloxane having at least two alkenyl groups in one molecule;
(B) from 0.1 part by weight to 50 parts by weight of an organohydrogenpolysiloxane having in one molecule at least two hydrogen atoms bonded to silicon atoms; and
(C) an effective amount of a catalyst for hydrosilylation reaction; and
has a Young's modulus of from 1 kgf/cm² to 12 kgf/cm² after its curing.

3. The process according to claim 1, wherein in said addition-curable organopolysiloxane composition a cyclic siloxane having a degree of polymerization of from 3 to 10 is in a content not more than 1,000 ppm by weight.

4. The process according to claim 3, wherein said cyclic siloxane having a degree of polymerization of from 3 to 10 is in a content of from 0 ppm to 600 ppm by weight.

5. The process according to claim 1, wherein said composition showing a Young's modulus of from 2 kgf/cm² to 10 kgf/cm² after its curing.

6. The process according to claim 2, wherein the component-(A) organopolysiloxane has in the molecule at least two alkenyl groups having 2 to 8 carbon atoms, bonded to silicon atoms constituting the backbone chain, and an organic group bonded to a silicon atom, other than the alkenyl group, is a substituted or unsubstituted monovalent hydrocarbon group having 1 to 12 carbon atoms.

7. The process according to claim 2, wherein the component-(A) organopolysiloxane has a viscosity of from 10 cP to 500,000 cP at 25° C.

8. The process according to claim 2, wherein the component-(B) organohydrogenpolysiloxane has at least three hydrogen atoms bonded to silicon atoms.

9. The process according to claim 2, wherein the component-(B) organohydrogenpolysiloxane has a viscosity of from 1 cP to 1,000 cP at 25° C.

10. The process according to claim 2, wherein the component (B) is mixed in such an amount that the hydrogen atoms bonded to silicon atoms in the component (B) are in a molar ratio of from 0.4 to 10 with respect to the alkenyl groups in the component (A).

11. An addition-curable organopolysiloxane composition for potting electronic component parts, comprising:
(A) 100 parts by weight of an organopolysiloxane having at least two alkenyl groups in one molecule;
(B) from 0.1 to 50 parts by weight of an organohydrogenpolysiloxane having in one molecule at least two hydrogen atoms bonded to silicon atoms; and
(C) an effective amount of a catalyst for hydrosilylation reaction; and
having a Young's modulus of from 1 to 12 kgf/cm² after its curing.
